# EUROPEAN PATENT SPECIFICATION

(11) **EP 3 179 163 B1**
(45) Date of publication and mention of the grant of the patent: **02.09.2020**
(21) Application number: 16194619.9
(22) Date of filing: 19.10.2016
(51) Int. Cl.: F21V 19/00, F21K 9/232, H01L 33/48, F21Y 115/10

(54) **A PARALLEL-CONNECTED LED ILLUMINANT AND A LED LIGHTING LAMP**
PARALLELGESCHALTETER LED-LEUCHTKÖRPER UND LED-LAMPE
SOURCE LUMINEUSE À DIODE ÉLECTROLUMINESCENTE CONNECTÉES EN PARALLÈLE ET LAMPE D'ÉCLAIRAGE À DEL

(30) Priority: 10.12.2015 CN 201510910158; 10.12.2015 CN 201521021761 U
(43) Date of publication of application: 14.06.2017
(73) Proprietor: Shandong Prosperous Star Optoelectronics Co., Ltd, Shandong Province (CN)
(72) Inventor: MA, Wenbo, Xintai, Shandong (CN); KONG, Yiping, Xintai, Shandong (CN); YUAN, Xincheng, Xintai, Shandong (CN); ZHOU, Minkang, Xintai, Shandong (CN)
(74) Representative: Sun, Yiming

(56) References cited:
- CN-A- 104 282 831
- CN-A- 104 600 181
- CN-A- 104 913 217
- CN-U- 203 810 164
- CN-U- 203 892 929

## Description

### Technical field

This invention relates to the field of lighting technology, and more particularly to a parallel-connected LED illuminant and a LED lighting lamp using the said parallel-connected LED illuminant as a light source.

In particular the invention relates to a parallel-connected LED illuminant comprising a parallel-connected bracket, at least one LED light emitting unit group and a fluorescent powder layer; wherein: said LED light emitting unit group is arranged in straight line on a linear substrate monomer along a long axis of the linear substrate monomer; said fluorescent powder layer fully covers the surface of the LED light emitting unit group on the linear substrate monomer, said linear substrate monomer is made of a metallic material or a ceramic material having a high heat conductivity coefficient, and only the surface of the linear substrate monomer provided with the LED light emitting unit group is covered with the fluorescent powder layer, and other surfaces of the linear substrate monomer are not covered with the fluorescent powder layer.

### Background art

CN 203892929 U discloses a parallel-connected LED illuminant of the generic type as specified above.

Specifically CN 203892929 U discloses a U-shaped LED luminous body and an LED illuminating lamp. The U-shaped LED luminous body comprises a U-shaped support; an LED luminous unit is arranged on the surface of the U-shaped support; and a fluorescent powder layer coats on the surface which is provided with the LED luminous unit. According to the U-shaped LED luminous body being provided with a heat conducting substrate, the fluorescent powder layer only coats the heat conducting substrate surface which is provided with the LED luminous unit, the fluorescent powder layer which is poor in thermal conductivity does not coat other surfaces, allowing other surfaces to directly contact with exterior heat dissipation gas to achieve heat exchange.

CN 104600181 A discloses a preparation method for an LED light bar. The preparation method comprises the steps of preparing a strip-shaped light transmitting substrate, forming and solidifying a plurality of first fluorescent powder layers on the light transmitting substrate, fixing an LED chip on every first fluorescent powder layer respectively, routing and connecting the LED chips, connecting the LED chips and electrodes and forming second fluorescent powder layers on the LED chips. The fluorescent powder layers are arranged on contact surfaces of the light transmitting substrate and the LED chips. 360-degree complete cycle light emitting of the LED light bar is achieved. Heat dissipation materials are added to the fluorescent powder layers.

The packaging forms for filament LED are increasingly concerned by people. Its principle is that LED chips are treated with die bonding on the line-like glass substrate, sapphire substrate or metal substrate. After wire bonding, the whole linear substrate is sealed with fluorescent powder glue layer to obtain a LED package emitting light at 360°. If it is assembled in a bulb lamp or a candle lamp, a light emitting effect which is approximate to incandescent light can be obtained.

However, this kind of packaging form has the following problems: (1) When filaments are produced with prior art, LED chips are of die attachment to linear substrate monomer. The filament bracket is composed of a single linear substrate monomer, so LED filament features relatively low power capacity, complicated filament welding, low efficiency and high product cost; (2) In the process of filament packaging, fluorescent powder glue covers the whole or most of the area of the substrate, which isolates the thermal dissipation channel of the substrate. Therefore, this kind of LED filament product in current market has such problems as ineffective thermal dissipation, failure to be driven by large current, short service life and high cost; (3) Even if transparent glass or sapphire substrate is adopted, there is still side leakage of blue light in the filament.

### Contents of the invention

To solve the above problems, this invention provides a parallel-connected LED illuminant and a LED lighting lamp which feature high power capacity, high productivity, good thermal dissipation, long service life and low cost.

To achieve the above purpose, technical solutions for this invention are as follows:
A parallel-connected LED illuminant comprising a parallel-connected bracket, at least one LED light emitting unit group and a fluorescent powder layer; wherein: said LED light emitting unit group is arranged in straight line on a linear substrate monomer along a long axis of the linear substrate monomer; said fluorescent powder layer fully covers the surface of the LED light emitting unit group on the linear substrate monomer, said linear substrate monomer is made of a metallic material or a ceramic material having a high heat conductivity coefficient, and only the surface of the linear substrate monomer provided with the LED light emitting unit group is covered with the fluorescent powder layer, wherein further said parallel-connected bracket comprises two or more than two paralleled linear substrate monomers, each LED light emitting unit group comprises a multiplicity of LED light emitting units connected in series, and the LED light emitting groups on different linear substrate monomers are connected in parallel, and said LED illuminant is in series connection with electrode pins at the ends of said parallel-connected bracket.

The linear substrate monomers and the linear substrate monomers are set in parallel.

Further, the LED light emitting unit group of different linear substrate monomer is on the same side as the parallel-connected bracket.

Further, the said LED light emitting unit is either or any of combinations among blue light LED chip, red light LED chip, green light LED chip, yellow light LED chip and purple light LED chip.

Further, the linear substrate monomer is 5mm-200mm in length, 0.3mm∼5mm in width and 0.1mm∼3mm in thickness. Preferably, the linear substrate monomer is 10mm∼100mm in length, 0.5mm∼2mm in width and 0.2mm∼1mm in thickness.

Further, the space between the adjacent linear substrate monomers of the parallel-connected bracket is 0.1mm∼20mm. Preferably, the space is 0.2mm∼5mm.

Further, the two sides of linear substrate monomers along the long axis is a plane, corrugated or serrated structure.

Further, the fluorescent powder layer fully covers on the surface of the LED light emitting unit of linear substrate monomer. The cross section contour of fluorescent powder layer is semicircular, semielliptical, rectangular or in any of other shapes. The fluorescent powder is yellow powder and yellow green powder under YAG series or yellow powder, yellow green powder and orange powder under silicate series, red powder under nitride and nitric oxide series or the combinations of fluorescent powder under various series.

This invention also provides a LED lighting lamp comprising a sealed transparent bulb shell, a light source in the transparent bulb shell and a gaseous medium with high thermal conductivity in the transparent bulb shell. The light source adopts the parallel-connected LED illuminant according to the invention. The gaseous medium with high thermal conductivity is helium, hydrogen or gas mixed with helium and hydrogen. In the mixed gas, the preferred volume ratio between helium and hydrogen is 95:5.

Compared with prior art, the beneficial effects of this invention are as follows:
(1) This invention provides a parallel-connected LED illuminant and a LED lighting lamp. The bracket of LED illuminant is formed by connecting two or more than two linear substrate monomers in parallel, which significantly enlarge the effective heat dissipation area of LED illuminant composed of single linear substrate monomer. As the surface of the LED light emitting unit provided in the linear substrate monomer is only wrapped with the fluorescent powder layer, and other surfaces are not wrapped by the fluorescent powder layer with poor thermal conductivity, other surfaces can directly contact with outside thermal dissipation gas to realize thermal exchange. This has enhanced the service life of LED lighting lamp. (2) The parallel-connected LED illuminant provided in this invention can bear higher power. (3) The bracket of LED illuminant is formed by connecting two or more than two linear substrate monomers in parallel, which can reduce the welding times during production, enhance welding efficiency and lower production cost.

### Brief description of the drawings

Fig. 1 is a diagram for parallel-connected bracket in this invention.
Fig. 2 is a diagram for parallel-connected LED illuminant in this invention.
Fig.3 is an enlarged diagram for Position A of parallel-connected LED illuminant in this invention.
Fig. 4 is a cross section diagram for linear substrate monomer of parallel-connected LED illuminant in this invention.
Fig. 5 is an effect diagram for removing bulb shell from parallel-connected LED bulb in this invention.

Where: 1-parallel-connected bracket; 2-LED light emitting unit; 3-fluorescent powder; 4-linear substrate monomer; 5-electrode pin; 6-LED light emitting unit group; 10-parallel-connected LED illuminant.

### Detailed description of preferred embodiments

Detailed description for this invention is given by combining drawings and embodiments so as to help the technicians in this field to learn about this invention.

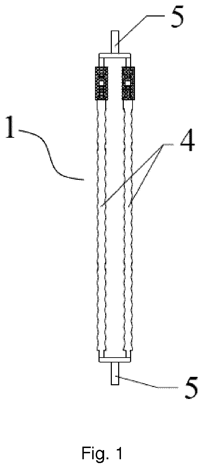

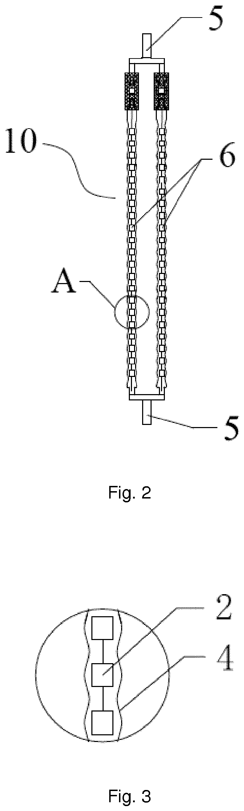

As shown in Fig.1 and Fig.2, this invention provides a parallel-connected LED illuminant 10 comprising a parallel-connected bracket 1, a LED light emitting unit group 6 and a fluorescent powder layer 3. The parallel-connected bracket comprises two or more than two paralleled linear substrate monomers 4. The linear substrate monomers 4 and the linear substrate monomers 4 are set in parallel. The LED light emitting unit group 6 comprises multiple series-connected LED light emitting units 2.

The LED light emitting units 2 are in series connection. The LED light emitting unit group 6 is arranged in straight line on the linear substrate monomer 4 along the long axis of linear substrate monomer 4. LED light emitting unit groups 6 on different linear substrate monomers 4 are in parallel connection. LED illuminant 10 is in series connection with electrode pins 5 at the end of parallel-connected bracket 1. A fluorescent powder layer 3 is coated on the surface of the LED light emitting unit group 6 provided in the linear substrate monomer 4.

In this embodiment, the LED light emitting unit group 6 of different linear substrate monomer 4 is on the same side as the parallel-connected bracket 1, as shown in Fig.2. The LED light emitting unit is either or any of combinations among blue light LED chip, red light LED chip, green light LED chip, yellow light LED chip and purple light LED chip. The linear substrate monomer 4 of the parallel-connected bracket 1 is made with the material with high heat conductivity coefficient. The material with high heat conductivity coefficient can be a metallic iron or a ceramic material. The linear substrate monomer 4 is 30mm in length, 1mm in width and 0.4mm in thickness. The width between the adjacent linear substrate monomers 4 of the parallel-connected bracket 1 is 1mm, and there is no filler between the two adjacent linear substrate monomers 4. In other embodiments, transparent resin can be used to fill the adjacent linear substrate monomers 4. The two sides of linear substrate monomer 4 of parallel-connected bracket 1 along the long axis are processed into a corrugated or indented concave-convex repetition structure. In other embodiments, the two sides of linear substrate monomer 4 of parallel-connected bracket 1 along the long axis can be a plane structure.

The total quantity of LED light emitting units 2 is 28, and the two linear substrate monomers 4 are set with 14 LED light emitting units respectively and set on the same side of the parallel-connected bracket 1 of the said LED light emitting units on the two linear substrate monomers 4. 14 LED light emitting units 2 set respectively on the two linear substrate monomers 4 are arranged in straight line on the surface of linear substrate monomers 4 along the long axis and in series connection.

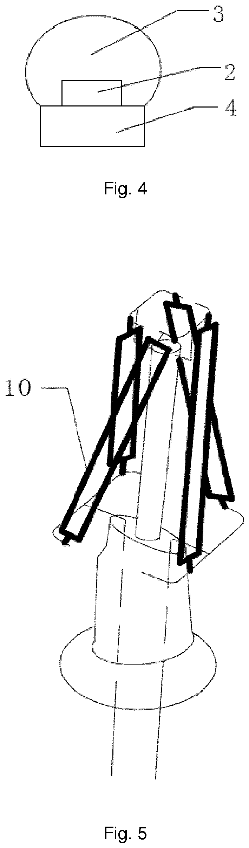

In this embodiment, a fluorescent powder layer 3 is coated on the surface of linear substrate monomer 4 set with the LED light emitting unit 2. The cross section contour of the fluorescent powder layer 3 is semicircle, as shown in Fig.4. The cross section contour of the fluorescent powder layer can also be semielliptical, rectangular or in any of other shapes. The fluorescent powder layer 3 will absorb some blue light and emits the yellow light with a longer wavelength. After mixing with the remaining blue light according to a certain proportion, it will form the white light with different color temperatures and color rendering indexes. The fluorescent powder in the fluorescent powder layer 3 is YAG yellow powder, yellow green powder and orange powder under silicate series or red powder under nitride and nitric oxide or the combinations of fluorescent powder under various series.

A LED lighting lamp prepared with parallel-connected LED illuminant comprises a sealed transparent bulb shell (preferred glass shell), a light source set in the glass shell and helium, hydrogen or gas mixed with helium and hydrogen with high thermal conductivity filled in the glass shell. In particular, the light source welded on the stem adopts the above parallel-connected LED illuminant.

The appearance of LED lighting lamp can set as bulb lamp, candle lamp and U -shaped lamp tube, etc. Through good thermal conducting characteristics of the metal substrate on the parallel-connected LED illuminant, it directly contacts with helium in the glass shell to realize thermal exchange, achieve a good thermal dissipation effect, improve the reliability of LED lighting lamp, have LED chip driven by higher current to obtain higher luminous flux or lumen value and greatly reduce the cost per unit lumen.

The above embodiments are only used to explain this invention but not limit the technical solutions described for this invention. Although detailed explanation has been given for this invention in this specification according to the above embodiments, the ordinary technicians in this field should understand that they can amend or replace this invention.

## Claims

1. A parallel-connected LED illuminant (10) comprising a parallel-connected bracket (1), at least one LED light emitting unit group (6) and a fluorescent powder layer (3); wherein
said LED light emitting unit group (6) is arranged in straight line on a linear substrate monomer (4) along a long axis of the linear substrate monomer (4);
said fluorescent powder layer (3) fully covers the surface of the LED light emitting unit group (6) on the linear substrate monomer (4),
said linear substrate monomer (4) is made of a metallic material or a ceramic material having a high heat conductivity coefficient, and
only the surface of the linear substrate monomer (4) provided with the LED light emitting unit group (6) is covered with the fluorescent powder layer (3), and other surfaces of the linear substrate monomer (4) are not covered with the fluorescent powder layer (3),
**characterized in that**
said parallel-connected bracket (1) comprises two or more than two paralleled linear substrate monomers (4),
each LED light emitting unit group (6) comprises a multiplicity of LED light emitting units (2) connected in series, and the LED light emitting groups (6) on different linear substrate monomers (4) are connected in parallel, and
said LED illuminant (10) is in series connection with electrode pins (5) at the ends of said parallel-connected bracket (1).

2. The parallel-connected LED illuminant (10) according to claim 1, **characterized in that** the LED light emitting unit groups (6) of different linear substrate monomers (4) are on the same side of the parallel-connected bracket (1).

3. The parallel-connected LED illuminant (10) according to claim 1, **characterized in that** each of said LED light emitting units (2) is either or any of combinations among blue light LED chip, red light LED chip, green light LED chip, yellow light LED chip and purple light LED chip.

4. The parallel-connected LED illuminant according to claim 1, **characterized in that** the linear substrate monomer (4) is 5mm-200mm in length, 0.3mm∼5mm in width and 0.1mm∼3mm in thickness, and the space between the linear substrate monomers (4) of the parallel-connected bracket (1) is 0.1mm∼20mm.

5. The parallel-connected LED illuminant according to claim 1, **characterized in that** the two sides of the said linear substrate monomers (4) along the long axis are a plane, corrugated or serrated structure.

6. The parallel-connected LED illuminant according to claim 1, **characterized in that** a cross section contour of said fluorescent powder layer (3) is semicircular, semielliptical or rectangular, wherein the fluorescent powder is yellow powder and yellow green powder under YAG series or yellow powder, yellow green powder and orange powder under silicate series or red powder under nitride and nitric oxide series.

7. An LED lighting lamp comprising a sealed transparent bulb shell, a light source in the said transparent bulb shell and a gaseous medium with high thermal conductivity in the said transparent bulb shell, **characterized in that** the said light source adopts the parallel-connected LED illuminant (10) as set forth in one of claims 1 to 6, wherein said gaseous medium with high thermal conductivity is helium, hydrogen or gas mixed with helium and hydrogen.

## Patentansprüche

1. Parallelgeschalteter LED-Leuchtkörper (10), welcher eine parallelgeschaltete Halterung (1), wenigstens eine Gruppe (6) von LED-Lichtemittereinheiten und eine fluoreszierende Pulverschicht (3) umfasst; wobei
die Gruppe (6)von LED-Lichtemittereinheiten in gerader Linie auf einem geradlinigen Monomersubstrat (4) entlang einer langen Achse des geradlinigen Monomersubstrats (4) angeordnet ist;
die fluoreszierende Pulverschicht (3) die Fläche der Gruppe (6) von LED-Lichtemittereinheiten auf dem geradlinigen Monomersubstrat (4) vollständig bedeckt,
das geradlinige Monomersubstrat (4) aus einem metallischen Material oder einem keramischen Material mit einem hohen Wärmeleitungskoeffizienten hergestellt ist, und nur die Fläche des geradlinigen Monomersubstrats (4), die mit der Gruppe (6) von LED-Lichtemittereinheiten versehen ist, mit der fluoreszierenden Pulverschicht (3) bedeckt ist und andere Flächen des geradlinigen Monomersubstrats (4) nicht mit der fluoreszierenden Pulverschicht (3) bedeckt sind,
**dadurch gekennzeichnet, dass**
die parallelgeschaltete Halterung (1) zwei oder mehr als zwei parallele geradlinige Monomersubstrate (4) umfasst,
jede Gruppe (6) von LED-Lichtemittereinheiten mehrere LED-Lichtemittereinheiten (2) umfasst, die in Reihe geschaltet sind, und die Gruppen (6) von LED-Lichtemittereinheiten auf verschiedenen geradlinigen Monomersubstraten (4) parallelgeschaltet sind, und
der LED-Leuchtkörper (10) mit Elektrodenstiften (5) an den Enden der parallelgeschalteten Halterung (1) in Reihe geschaltet ist.

2. Parallelgeschalteter LED-Leuchtkörper (10) nach Anspruch 1, **dadurch gekennzeichnet, dass** sich die Gruppen (6) von LED-Lichtemittereinheiten auf verschiedenen geradlinigen Monomersubstraten (4) auf derselben Seite der parallelgeschalteten Halterung (1) befinden.

3. Parallelgeschalteter LED-Leuchtkörper (10) nach Anspruch 1, **dadurch gekennzeichnet, dass** jede der LED-Lichtemittereinheiten (2) einer oder eine der Kombinationen von einem Blaulicht-LED-Chip, Rotlicht-LED-Chip, Grünlicht-LED-Chip, Gelblicht-LED-Chip und Violettlicht-LED-Chip ist.

4. Parallelgeschalteter LED-Leuchtkörper nach Anspruch 1, **dadurch gekennzeichnet, dass** das geradlinige Monomersubstrat (4) eine Länge von 5 mm - 200 mm, eine Breite von 0,3 mm - 5 mm und eine Dicke von 0,1 mm - 3 mm aufweist und der Zwischenraum zwischen den geradlinigen Monomersubstraten (4) der parallelgeschalteten Halterung (1) 0,1 mm - 20 mm beträgt.

5. Parallelgeschalteter LED-Leuchtkörper nach Anspruch 1, **dadurch gekennzeichnet, dass** die zwei Seiten des geradlinigen Monomersubstrat (4) entlang der langen Achse eine ebene, gewellte oder gezahnte Struktur sind.

6. Parallelgeschalteter LED-Leuchtkörper nach Anspruch 1, **dadurch gekennzeichnet, dass** eine Querschnittskontur der fluoreszierenden Pulverschicht (3) halbkreisförmig, halbellipsenförmig oder rechteckig ist, wobei das fluoreszierende Pulver gelbes Pulver und gelbgrünes Pulver aus der YAG-Reihe oder gelbes Pulver, gelbgrünes Pulver und oranges Pulver aus der Silikat-Reihe oder rotes Pulver aus der Nitrid- und Stickoxid-Reihe ist.

7. LED-Lampe, welche einen abgedichteten, durchsichtigen Lampenkolben, eine Lichtquelle in dem durchsichtigen Lampenkolben und ein gasförmiges Medium mit hoher Wärmeleitfähigkeit in dem durchsichtigen Lampenkolben umfasst, **dadurch gekennzeichnet, dass** die Lichtquelle den parallelgeschalteten LED-Leuchtkörper (10) nach einem der Ansprüche 1 bis 6 verwendet, wobei das gasförmige Medium mit hoher Wärmeleitfähigkeit Helium, Wasserstoff oder ein Helium und Wasserstoff enthaltendes Gasgemisch ist.

## Revendications

1. Illuminateur LED connecté en parallèle (10) comprenant un support connecté en parallèle (1), au moins un groupe d'unités électroluminescentes LED (6) et une couche de poudre fluorescente (3); dans lequel
ledit groupe d'unités électroluminescentes LED (6) est disposé en ligne droite sur un monomère de substrat linéaire (4) le long d'un axe long du monomère de substrat linéaire (4);
ladite couche de poudre fluorescente (3) recouvre entièrement la surface du groupe d'unités électroluminescentes LED (6) sur le monomère de substrat linéaire (4),
ledit monomère de substrat linéaire (4) est constitué d'un matériau métallique ou d'un matériau céramique ayant un coefficient de conductivité thermique élevé,
et uniquement la surface du monomère de substrat linéaire (4) pourvu du groupe d'unités électroluminescentes LED (6) est recouvert de la couche de poudre fluorescente (3), et les autres surfaces du monomère de substrat linéaire (4) ne sont pas recouvertes de la couche de poudre fluorescente (3),
**caractérisé en ce que**
ledit support connecté en parallèle (1) comprend deux ou plus de deux substrats monomères linéaires en parallèle (4),
chaque groupe d'unités électroluminescentes LED (6) comprend une multiplicité d'unités électroluminescentes LED (2) connectées en série, et les groupes électroluminescents LED (6) sur différents monomères de substrat linéaire (4) sont connectés en parallèle, et
ledit illuminateur LED (10) est connecté en série avec des broches d'électrode (5) aux extrémités dudit support (1) connecté en parallèle.

2. Illuminateur LED connecté en parallèle (10) selon la revendication 1, **caractérisé en ce que** les groupes d'unités électroluminescentes LED (6) de différents monomères de substrat linéaire (4) sont du même côté du support connecté en parallèle (1).

3. Illuminateur LED (10) connecté en parallèle selon la revendication 1, **caractérisé en ce que** chacune desdites unités électroluminescentes à LED (2) est l'une ou l'autre des combinaisons parmi une puce LED à lumière bleue, puce LED à lumière rouge, puce LED à lumière verte, puce LED à lumière jaune et puce LED à lumière violette.

4. Illuminateur LED connecté en parallèle selon la revendication 1, **caractérisé en ce que** le monomère de substrat linéaire (4) a une longueur de 5 mm-200 mm, une largeur de 0,3 mm-5 mm et une épaisseur de 0,1 mm-3 mm et l'espace entre les monomères de substrat linéaires (4) du support connecté en parallèle (1) est de 0,1 mm à 20 mm.

5. Illuminateur LED connecté en parallèle selon la revendication 1, **caractérisé en ce que** les deux côtés desdits monomères de substrats linéaires (4) le long de l'axe long ont une structure plane, ondulée ou dentelée.

6. Illuminateur LED connecté en parallèle selon la revendication 1, **caractérisé en ce qu'**un contour de section transversale de ladite couche de poudre fluorescente (3) est semi-circulaire, semi-elliptique ou rectangulaire, dans lequel la poudre fluorescente est une poudre jaune et une poudre vert jaune sous la série YAG ou une poudre jaune, une poudre jaune vert et une poudre orange sous la série silicate ou une poudre rouge sous les séries nitrure et oxyde nitrique.

7. Lampe d'éclairage à LED comprenant une enveloppe d'ampoule transparente scellée, une source de lumière dans ladite enveloppe d'ampoule transparente et un milieu gazeux à haute conductivité thermique dans ladite enveloppe d'ampoule transparente, **caractérisé en ce que** ladite source de lumière adopte ledit illuminateur LED connecté en parallèle (10) selon une des revendications 1 à 6, dans lequel ledit milieu gazeux à haute conductivité thermique est de l'hélium, de l'hydrogène ou du gaz mélangé à de l'hélium et de l'hydrogène.
